# EUROPÄISCHE PATENTSCHRIFT

(11) **EP 1 002 141 B1**
(45) Veröffentlichungstag und Bekanntmachung des Hinweises auf die Patenterteilung: **19.02.2003**
(21) Anmeldenummer: 98947318.6
(22) Anmeldetag: 20.07.1998
(51) Int. Cl.: C23C 16/14, C23C 30/00, F01D 5/28

(54) **HOCHTEMPERATURBESTÄNDIGES BAUTEIL UND VERFAHREN ZUR HERSTELLUNG EINES OXIDATIONSSCHUTZES**
COMPONENT WITH HIGH TEMPERATURE RESISTANCE AND METHOD FOR PRODUCING AN ANTI-OXIDATION ELEMENT
COMPOSANT RESISTANT AUX TEMPERATURES ELEVEES ET PROCEDE DE REALI SATION D'UNE PROTECTION ANTIOXYDATION

(30) Priorität: 31.07.1997 DE 19733146
(43) Veröffentlichungstag der Anmeldung: 24.05.2000
(60) Teilanmeldung: 02019668.9
(73) Patentinhaber: SIEMENS AKTIENGESELLSCHAFT, 80333 München (DE)
(72) Erfinder: CZECH, Norbert, D-46286 Dorsten (DE)
(86) Internationale Anmeldenummer: DE9802036
(87) Internationale Veröffentlichungsnummer: WO99006609

(56) Entgegenhaltungen:
- EP-A- 0 607 651
- EP-A- 0 846 788
- DE-A- 3 612 135
- LANE S J ET AL: "LOW-PRESSURE PHOTOCHEMICAL VAPOUR DEPOSITION OF GALLIUM METAL FROM AN IODIDE PRECURSOR" JOURNAL OF THE CHEMICAL SOCIETY. FARADAY TRANSACTIONS, Bd. 87, Nr. 7, 7. April 1991, Seiten 995-1001, XP000204482
- MARINKOVIC Z ET AL: "Room temperature interactions in Ni/metal thin film couples" THIN SOLID FILMS, 10 DEC. 1982, SWITZERLAND, Bd. 98, Nr. 2, Seiten 95-100, XP002088135 ISSN 0040-6090

## Beschreibung

Die Erfindung betrifft ein hochtemperaturbeständiges Bauteil sowie ein Verfahren zur Herstellung eines Oxidationsschutzes für ein hochtemperaturbeständiges Bauteil.

Aus der US-PS 4,321,310 ist ein zusammengesetztes Beschichtungssystem zum Schutz eines metallischen Bauteils, insbesondere bei hohen Temperaturen, beschrieben. Insbesondere ist ein Beschichtungssystem für eine Gasturbinenschaufel erläutert. Eine Gasturbinenschaufel ist einer starken Beanspruchung durch hohe Temperaturen und starker Oxidation ausgesetzt. Um den hohen Temperaturen widerstehen zu können, werden Gasturbinenschaufeln verbreitet aus einer Nickel-Basisoder einer Kobalt-Basis-Superlegierung gefertigt, welche einen ausreichend hohen Schmelzpunkt aufweisen. In der Regel besteht zudem die Notwendigkeit, die Oberfläche einer solchen Gasturbinenschaufel gegen Oxidation zu schützen. Dies kann durch eine MCrAlY-Beschichtung erreicht werden. M steht hierbei für wenigstens eines der Elemente Eisen, Kobalt oder Nickel, Cr bedeutet Chrom, Al Aluminium und Y Yttrium. Der Oxidationsschutz wird dadurch erreicht, daß sich an der Oberfläche einer solchen Beschichtung ein sehr oxidationsbeständiges Aluminiumoxid bildet. In der genannten Druckschrift wird auf eine solche Beschichtung einer Gasturbinenschaufel zusätzlich eine Keramikbeschichtung aufgebracht. Diese Keramikbeschichtung wirkt als Wärmedämmschicht. zwischen Wärmedämmschicht und Oxidationsschicht ist eine Aluminiumschicht angeordnet. Diese verbessert insbesondere die Haftung der Keramikschicht auf der Oxidationsschutzschicht.

In der WO 97/07252 ist ein Erzeugnis zur Führung eines heißen, oxidierenden Gases beschrieben. Insbesondere ist ein thermisch hoch belastetes Bauteil einer Gasturbine gemeint.

Es ist beschrieben, daß metallische Schutzschichten aus MCrAlY in ihrer Oxidationsbeständigkeit im Laufe der Zeit dadurch beeinträchtigt sind, daß die Schutzschicht kontinuierlich an Aluminium verarmt. Eine solche Verarmung geschieht dadurch, daß sich der Oxidfilm im Einsatz des Bauteils stetig abnutzt, wobei kontinuierlich Aluminium aus der Schutzschicht an die Oberfläche nachdiffundiert. Dementsprechend bemißt sich die maximale Lebensdauer einer Schutzschicht an ihrem Aluminiumgehalt. Unter dem Aspekt der Langlebigkeit ist also ein hoher Gewichtsanteil von Aluminium in einer Legierung für eine Schutzschicht erwünscht. Allerdings führt ein hoher Gewichtsanteil von Aluminium dazu, daß die Legierung versprödet. Das Aluminium ist nämlich nicht in elementarer Form in der Legierung gespeichert, sondern, zumindest zu einem wesentlichen Anteil, in Form intermetallischer Verbindungen, insbesondere intermetallischer Verbindungen aus Nickel und Aluminium oder Kobalt und Aluminium. Durch unterschiedliche Eigenschaften, insbesondere unterschiedliche thermische Ausdehnungskoeffizienten dieser intermetallischen Verbindungen, ergibt sich die besagte Versprödung. Damit ist der Gewichtsanteil von Aluminium in der Schutzschicht stark beschränkt. Es wird ausgeführt, daß eine Zulegierung von Gallium zur Schutzschicht die gewünschte Oxidationsbeständigkeit sicherstellt, wobei die Zulegierung von Gallium gleichzeitig dazu führt, daß die Duktilität der Schutzschicht verbessert, d.h. die Sprödheit der Schutzschicht verringert wird.

Die EP846 788 A1 zeigt ein Substrat aus einer Nickel- oder Kobaltbasis-Superlegierung als Grundwerkstoff mit Gallium, auf der eine Anreicherungsschicht aufgebracht ist. Die Anreicherungsschicht besteht aus einer kontinuierlichen Matrix einer gamma-Phase von Chrom gelöst in Nickel oder Cobalt, die durch Chromierung enstanden ist.

Die Anreicherungsschicht umfasst granular verteilte Ausscheidungen einer intermetallischen Verbindung aus Nickel und Gallium Ni-Ga. Auf der Anreicherungsschicht bildet sich eine Oxidschicht auf Galliumbasis. Auf diese Anreicherungsschicht mit der Oxidschicht auf Galliumbasis kann noch eine MCrAlY Schicht aufgebracht werden.

Aufgabe der Erfindung ist es, ein hochtemperaturbeständiges Bauteil anzugeben. Weitere Aufgabe der Erfindung ist die Angabe eines Verfahrens zur Herstellung eines Oxidationsschutzes für ein hochtemperaturbeständiges Bauteil.

Erfindungsgemäß wird die auf die Angabe eines Bauteils gerichtete Aufgabe gelöst durch ein hochtemperaturbeständiges Bauteil aus einer Nickel-Basis- oder Kobalt-Basis-Superlegierung als Grundwerkstoff gemäss Anspruch 1 und 2.
Der Oxidationsschutzüberzug gemäss Anspruch 1 kann dadurch erzeugt werden, dass Gallium auf das Bauteil aufgebracht wird.

Mit dem Begriff "Galliumbasis" ist gemeint, daß der Oxidationsschutzüberzug zum überwiegenden Teil aus Gallium besteht. Der Oxidationsschutzüberzug muß nicht das gesamte Bauteil überziehen, es kann bzw. können auch nur ein Bereich oder mehrere Bereiche überzogen sein. Ein solcher Oxidationsschutzüberzug bietet eine Oxidationsbeständigkeit vergleichbar mit einer Aluminiumschicht, da Gallium, wie auch Aluminium, ein sehr beständiges Oxid ausbildet, welches unter dieser Oxidschicht liegendes Material effektiv schützt. Insbesondere hat ein Oxidationsschutzüberzug auf Galliumbasis den Vorteil, ein darunter liegendes Material, welches Eisen, Kobalt oder Nickel enthält, nicht wesentlich zu verspröden. Aus einem Oxidationsschutzüberzug auf Aluminiumbasis -auch als "Alitierung" bezeichnet- würde Aluminium in ein solches Material hineindiffundieren. Dies hätte die Bildung intermetallischer Phasen zur Folge, welche durch ihre Sprödheit -wie oben ausgeführt-, zu einer erheblichen Versprödung des Grundwerkstoffes führen würde. Auch Gallium diffundiert in den Grundwerkstoff. Die sich dadurch ausbildenden intermetallischen Phasen sind aber deutlich duktiler. Demnach führt ein Oxidationsschutzüberzug auf Galliumbasis zu einer deutlich geringeren, in den Schichteigenschaften beherrschbaren Versprödung.
Ebenso ist es möglich eine Schutzlegierung auf das Bauteil aufzubringen, auf die ein Oxidationsschutzüberzug auf Galliumbasis aufgebracht ist. Dabei besteht die Schutzlegierung aus der Klasse der MCrAlY-Legierungen, wobei
a) M mindestens ein Metall aus der Gruppe (Nickel, Kobalt, Eisen),
b) Cr Chrom,
c) Al Aluminium und
d) Y für Yttrium und/oder für ein Metall aus der Gruppe der (Scandium, Lanthan, Cer) steht,
auf welche Schutzlegierung der Oxidationsschutzüberzug aufgebracht ist.
Gerade ein Oxidationsschutzüberzug der genannten Art ist anfällig für eine Versprödung durch Bildung intermetallischer Phasen mit Aluminium, wenn ein Oxidationsschutzüberzug auf Aluminiumbasis aufgebracht wird. Der einerseits verbesserte Oxidationsschutz durch Aufbringen von Aluminium führt andererseits in der Regel zu einer kaum beherrschbaren Rißanfälligkeit der Schutzschicht. Dementsprechend können z.B. Gasturbinenschaufeln, die eine solche Schutzlegierung aufweisen, nicht oder nur unter hohem Aufwand mit einem zusätzlichen Oxidationsschutz durch Aufbringen von Aluminium versehen werden. Solche Schutzlegierungen müssen durch aufwendige Abdeckungen gegen ein an der übrigen Schaufel durchgeführtes Aufbringen einer Aluminiumschicht gesichert, oder in einer anschließenden, aufwendigen Bearbeitung vom Aluminium befreit werden. Indem Gallium statt Aluminium aufgebracht wird, können auch diese Schutzlegierungen mit einem zusätzlichen Oxidationsschutz versehen werden, ohne sie unangemessen zu verspröden. Bevorzugt liegt angrenzend an den Oxidationsschutzüberzug eine Zone einer intermetallischen Phase, umfassend Gallium, Nickel und/oder Kobalt vor.

Weiter bevorzugt ist das Bauteil eine Komponente einer Gasturbinenanlage, insbesondere einer Gasturbinenschaufel, oder ein Element für eine Brennkammerauskleidung. Gerade solche Bauteile einer Gasturbinenanlage sind sehr hohen Temperaturen und entsprechend hohen Oxidationen unterworfen. Ein sicherer und langlebiger Oxidationsschutz ist für solche Bauteile eine zentral wichtige Eigenschaft.

Bevorzugt ist das Bauteil eine Gasturbinenschaufel einer stationären Gasturbine. Weiter bevorzugt ist das Bauteil eine Gasturbinenschaufel eines Flugtriebwerks.

Bevorzugtermaßen weist die Gasturbinenschaufel einen Kühlkanal mit einer Kühlkanalwand auf, auf welcher Kühlkanalwand zumindest teilweise der Oxidationsschutzüberzug aufgebracht ist. Gasturbinenschaufeln werden häufig gekühlt. Diese Kühlung wird in der Regel dadurch erreicht, daß die Gasturbinenschaufel mit einer inneren Kühlstruktur aus einer Vielzahl von Kühlkanälen versehen wird, durch die ein kühlendes Gas, z.B. Luft, geführt wird. Auch diese Kühlkanäle sind einer Oxidation unterworfen, die durch einen wirksamen und langlebigen Oxidationsschutzüberzug auf Galliumbasis erheblich reduziert werden kann.

Erfindungsgemäß wird die auf Angabe eines Verfahrens gerichtete Aufgabe gelöst durch ein Verfahren zur Herstellung eines Oxidationsschutzes für ein hochtemperaturbeständiges Bauteil, insbesondere eine Gasturbinenschaufel, welches Bauteil aus einer Nickel-Basis- oder aus einer Kobalt-Basis-Superlegierung als Grundwerkstoff gefertigt ist, wobei Gallium auf das Bauteil zur Bildung eines Oxidationsschutzüberzuges aufgebracht wird.

Die Vorteile eines solchen Verfahrens ergeben sich entsprechend den obigen Ausführungen zu den Vorteilen des Oxidationsschutzüberzuges auf Galliumbasis für ein hochtemperaturbeständiges Bauteil.

Bevorzugt wird auf den Grundwerkstoff eine Schutzlegierung aus einer MCrAlY-Legierung aufgebracht, wobei
a) M mindestens ein Metall aus der Gruppe (Nickel, Kobalt, Eisen),
b) Cr Chrom,
c) Al Aluminium und
d) Y für Yttrium und/oder für ein Metall aus der Gruppe (Scandium, Lanthan, Cer) steht,
auf welche Schutzlegierung das Gallium aufgebracht wird.

Weiter bevorzugt wird das Bauteil bei hohen Temperaturen einem Gallium-Halogenidgas ausgesetzt, wobei Gallium auf das Bauteil abgeschieden wird. Ein solches Verfahren ermöglicht es in einfacher Weise, Gallium aus der Gasphase gleichmäßig auf die Oberfläche des Bauteils zur Bildung eines Oxidationsschutzüberzuges aufzubringen.

Bevorzugt ist das Bauteil eine Gasturbinenschaufel mit einem Kühlkanal, durch den bei hohen Temperaturen ein Gallium-Halogenidgas geleitet wird, aus welchem Gas Gallium auf die Kanalwand des Kühlkanals abgeschieden wird. Dieses Verfahren hat insbesondere den Vorteil, einen Kühlkanal einer Gasturbinenschaufel gleichmäßig mit einem Oxidationsschutzüberzug zu versehen. Ein entsprechendes Verfahren, mit dem Aluminium als Oxidationsschutzüberzug auf die Kühlkanalwand aufgebracht wird, hat den Nachteil, daß bei Eintritt des Gases in den Kühlkanal ein hoher Anteil an Aluminium bereits frühzeitig abgeschieden wird, so daß zu weiter hinten liegenden Bereichen der Kanalwand nur noch wenig Aluminium gelangt. Dies beruht auf einem relativ hohen Diffusionskoeffizienten für Aluminium in einer Superlegierung. Gallium weist demgegenüber eine geringere Diffusion in einer Superlegierung auf und wird dementsprechend gleichmäßiger auf der Kühlkanalwand verteilt.

Die Erfindung wird in einem Ausführungsbeispiel anhand der Zeichnung näher erläutert. Es zeigen:
- FIG 1: eine Gasturbinenschaufel,
- FIG 2: einen Ausschnitt eines Querschnitts durch eine Gasturbinenschaufel, und
- FIG 3: einen Querschnitt durch eine Gasturbinenschaufel mit einer Kühlstruktur.
- FIG 4: einen Hitzeschild für eine Brennkammerauskleidung.

Gleiche Bezugszeichen haben in den verschiedenen Figuren die gleiche Bedeutung.

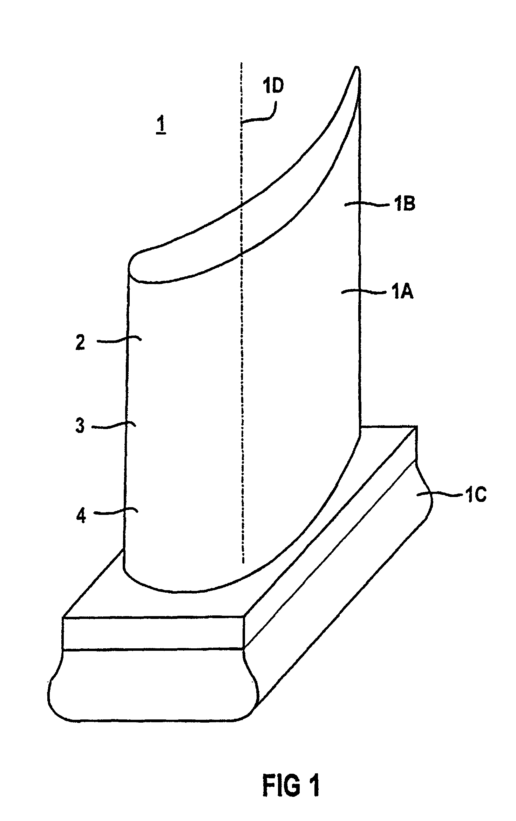

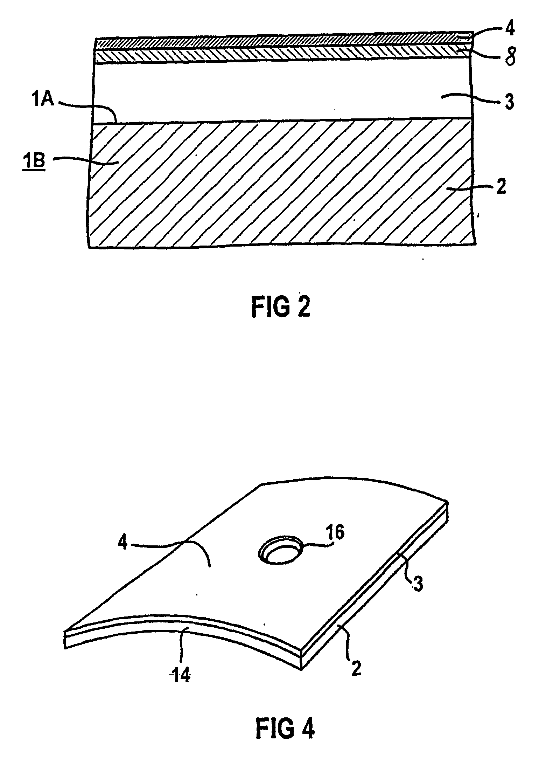

In Figur 1 ist ein Bauteil 1 / eine Gasturbinenschaufel 1 dargestellt. Sie weist ein entlang einer Achse 1D gerichtetes Schaufelblatt 1B auf. An das Schaufelblatt 1B grenzt ein Fußteil 1C. Die Schaufel 1 wird aus einem Grundwerkstoff 2 gefertigt. Dieser Grundwerkstoff 2 ist eine Nickel-Basis- oder Kobalt-Basis-Superlegierung. Die Schaufel 1 weist eine Schaufeloberfläche 1A mit einer Beschichtung auf, die anhand von Fig. 2 näher erläutert wird.

Fig. 2 zeigt einen Ausschnitt eines Querschnittes durch das Schaufelblatt 1B aus Fig. 1. Auf die Oberfläche 1A des Grundwerkstoffes 2 ist eine Schutzlegierung 3 aufgebracht. Diese Schutzlegierung 3 besteht aus einer Legierung des Typs MCrAlY, wobei M für ein Metall aus der Gruppe Eisen, Kobalt, Nickel besteht. Cr steht für Chrom und Al für Aluminium. Y steht für Yttrium und kann auch ganz oder teilweise ersetzt werden durch Scandium, Lanthan oder Cer. Auf die Schutzlegierung 3 ist ein Oxidationsschutzüberzug 4 auf einer Galliumbasis aufgebracht. Vorzugsweise ist der Oxidationsschutzüberzug 4 eine im wesentlichen reine Galliumschicht. Das Gallium diffundiert aus dem Oxidationsschutzüberzug 4 in die Schutzlegierung 3. Innerhalb einer Zone 8 bildet es mit dem Nickel oder dem Kobalt der Schutzlegierung 3 intermetallische Verbindungen. Im Gegensatz zu einem Oxidationsschutzüberzug 4 aus Aluminium führt dies jedoch nicht dazu, daß die Schutzschicht 3 übermäßig versprödet, da diese intermetallischen Verbindungen eine höhere Duktilität der Zone 8 zur Folge haben.

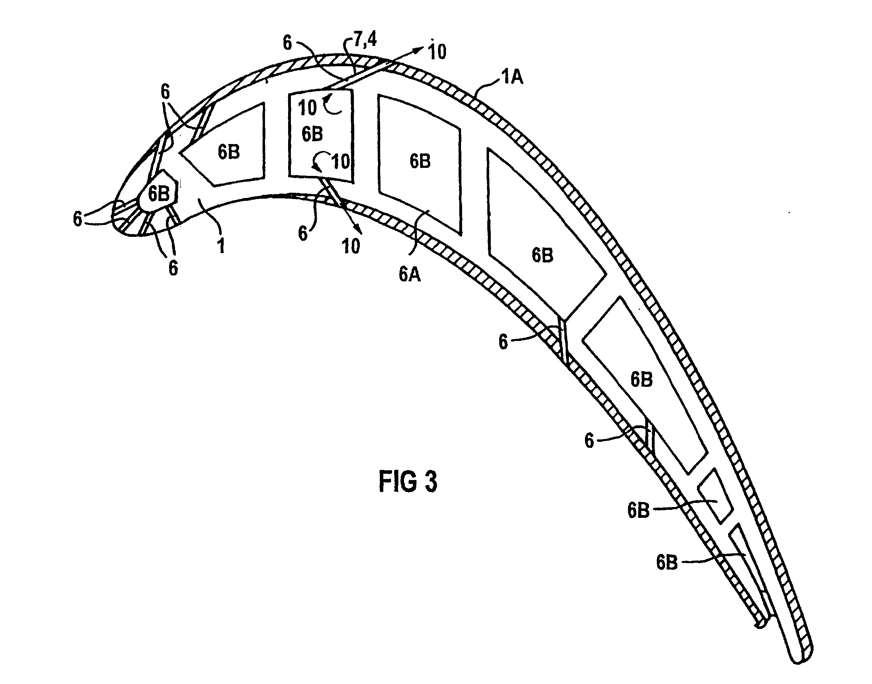

In Figur 3 ist ein Querschnitt durch eine Gasturbinenschaufel 1 gezeigt. Die Gasturbinenschaufel 1 weist eine Kühlstruktur 6A auf. Diese besteht im wesentlichen aus Hohlräumen 6B, von denen Kühlkanäle 6 an die Oberfläche 1A der Gasturbinenschaufel 1 führen. Die Kühlkanäle 6 der Gasturbinenschaufel 1 weisen jeweils eine Kanalwand 7 auf. Um diese Kanalwände 7 gegen Oxidation beständiger zu machen, wird bei hohen Temperaturen ein Gallium-Halogenid-Gas 10 in die Kühlstruktur 6A der Gasturbinenschaufel 1 gedrückt. Aus diesem heißen Gas 10 scheidet sich Gallium an den Kühlkanalwänden 7 ab. Damit wird ein sicherer und langlebiger Oxidationsschutzüberzug 4 hergestellt. Im Gegensatz zu einem entsprechenden Verfahren mit Aluminium kann durch Gallium eine gleichmäßigere Beschichtung der Kühlkanalwände 7 erfolgen, da Gallium weniger schnell in die Superlegierung 2 eindiffundiert. Selbstverständlich können alle Wände der Kühlstruktur 6A, also auch die Wände der Hohlräume 6B mit dem Oxidationsschutzüberzug 4 versehen werden.

In Fig. 4 ist ein Element 14 / Hitzeschild 14 für eine Brennkammerauskleidung gezeigt. Auf einen Grundwerkstoff 2 ist eine MCrAlY-Schutzlegierung 3 aufgebracht. Diese ist mit einem Oxidationsschutzüberzug 4, welcher aus Gallium besteht, versehen. Die Öffnung 16 dient der Befestigung des Elementes 14.

### Bezugszeichenliste

- 1: Gasturbinenschaufel
- 1A: Schaufeloberfläche
- 1B: Schaufelblatt
- 1C: Fußteil
- 1D: Achse
- 2: Grundwerkstoff
- 3: Schutzlegierung
- 4: Oxidationsschutzschicht
- 6: Kühlkanal
- 6A: Kühlstruktur
- 6B: Hohlraum
- 8: Diffusionszone
- 10: Gallium-Halogenid-Gas
- 14: Hitzeschild
- 16: Öffnung

## Patentansprüche

1. Hochtemperaturbeständiges Bauteil (1) aus einer Nickel-Basis- oder Kobalt-Superlegierung als Grundwerkstoff (2), auf das Gallium aufgebracht ist, das einen Oxidationsschutzüberzug (4) auf Gallium-Basis bildet.

2. Hochtemperaturbeständiges Bauteil (1) nach Anspruch 1 aus einer Nickel-Basis- oder Kobalt-Superlegierung als Grundwerkstoff (2), mit einer Schutzlegierung (3) aus der Klasse der MCrAlY-Legierungen, auf die (3) ein Oxidationsschutzüberzug (4) auf Gallium-Basis aufgebracht ist,
wobei
a) M mindestens ein Metall aus der Gruppe (Nickel, Kobalt, Eisen),
b) Cr Chrom,
c) Al Aluminium und
d) Y für Yttrium und/oder ein Metall aus der Gruppe (Scandium, Lanthan, Cer) ist,
auf welche Schutzlegierung (3) der Oxidationsschutzüberzug (4) aufgebracht ist.

3. Bauteil (1) nach Anspruch 2,
wobei zwischen dem Oxidationsschutzüberzug (4) und der Schutzlegierung (3) eine Zone (8) einer intermetallischen Phase, umfassend Gallium, Nickel und/oder Kobalt, vorliegt.

4. Bauteil (1) nach einem der vorhergehenden Ansprüche, welches eine Komponente (1) einer Gasturbinenanlage, insbesondere eine Gasturbinenschaufel (1) oder ein Element (14) für eine Brennkammerauskleidung, ist.

5. Bauteil (1) nach Anspruch 4,
welches eine Gasturbinenschaufel (1) einer stationären Gasturbine ist.

6. Bauteil (1) nach Anspruch 4,
welches eine Gasturbinenschaufel (1) eines Flugtriebwerks ist.

7. Bauteil (1) nach Anspruch 5 oder 6,
welches einen Kühlkanal (6) mit einer Kühlkanalwand (7) aufweist, auf welche Kühlkanalwand (7) zumindest teilweise der Oxidationsschutzüberzug (4) aufgebracht ist.

8. Verfahren zur Herstellung eines Oxidationsschutzes für ein hochtemperaturbeständiges Bauteil (1), insbesondere eine Gasturbinenschaufel (1), welches Bauteil (1) aus einer Nickel-Basis- oder aus einer Kobalt-Basis-Superlegierung als Grundwerkstoff (2) gefertigt ist, wobei Gallium auf das Bauteil (1) zur Bildung eines Oxidationsschutzüberzuges (4) aufgebracht wird.

9. Verfahren nach Anspruch 8,
bei dem auf den Grundwerkstoff (2) eine Schutzlegierung (3) aus der Klasse der MCrAlY-Legierungen aufgebracht ist,
wobei
a) M mindestens ein Metall aus der Gruppe (Nickel, Kobalt, Eisen),
b) Cr Chrom,
c) Al Aluminium und
d) Y für Yttrium und/oder für ein Metall aus der Gruppe (Scandium, Lanthan, Cer) steht,
auf welche Schutzlegierung (3) das Gallium aufgebracht wird.

10. Verfahren nach Anspruch 8 oder 9,
bei dem das Bauteil (1) bei hohen Temperaturen einem Gallium-Halogenid-Gas (10) ausgesetzt und dabei Gallium auf das Bauteil (1) abgeschieden wird.

11. Verfahren nach einem der Ansprüche 8 bis 10,
wobei das Bauteil (1) eine Gasturbinenschaufel (1) mit einem Kühlkanal (6) ist, durch den bei hohen Temperaturen ein Gallium-Halogenid-Gas (10) geleitet wird, aus welchem Gallium-Halogenid-Gas Gallium auf die Kanalwand (7) des Kühlkanals (6) abgeschieden wird.

## Claims

1. High-temperature-resistant component (1) comprising a nickel-based or cobalt-based superalloy as base material (2) to which gallium is applied to form an antioxidation coating (4) based on gallium.

2. High-temperature-resistant component (1) according to Claim 1, comprising a nickel-based or cobalt-based superalloy as base material (2), having a protective alloy (3) selected from the class of MCrAlY alloys, to which (3) an antioxidation coating (4) based on gallium is applied, where
a) M is at least one metal selected from the group consisting of nickel, cobalt and iron,
b) Cr is chromium,
c) Al is aluminium and
d) Y is yttrium and/or a metal selected from the group consisting of scandium, lanthanum and cerium,
is applied to the base material (2), to which protective alloy (3) the antioxidation coating (4) is applied.

3. Component (1) according to Claim 2, wherein a zone (8) of an intermetallic phase comprising gallium, nickel and/or cobalt is present between the antioxidation coating (4) and the protective alloy (3).

4. Component (1) according to any of the preceding claims which is a part (1) of a gas turbine unit, in particular a gas turbine blade (1) or an element (14) for a combustion chamber lining.

5. Component (1) according to Claim 4, which is a gas turbine blade (1) of a stationary gas turbine.

6. Component (1) according to Claim 4, which is a gas turbine blade (1) of an aircraft engine.

7. Component (1) according to Claim 5 or 6, which has a cooling channel (6) with a cooling channel wall (7) which cooling channel wall (7) is provided at least in part with the antioxidation coating (4).

8. Method of protecting a high-temperature-resistant component (1), in particular a gas turbine blade (1), made of a nickel-based or cobalt-based superalloy as base material (2) against oxidation, wherein gallium is applied to the component (1) to form an antioxidation coating (4).

9. Method according to Claim 8, wherein a protective alloy (3) selected from the class consisting of MCrAlY alloys, where
a) M is at least one metal selected from the group consisting of nickel, cobalt and iron,
b) Cr is chromium,
c) Al is aluminium and
d) Y is yttrium and/or a metal selected from the group consisting of scandium, lanthanum and cerium,
is applied to the base material (2), to which protective alloy (3) the gallium is applied.

10. Method according to Claim 8 or 9, wherein the component (1) is exposed to a gallium halide gas (10) at high temperatures and gallium is thus deposited on the component (1).

11. Method according to any of Claims 8 to 10, wherein the component (1) is a gas turbine blade (1) having a cooling channel (6) through which a gallium halide gas (10) is conveyed at high temperatures and gallium is deposited from this gallium halide gas onto the channel wall (7) of the cooling channel (6).

## Revendications

1. Elément (1) résistant aux hautes températures en un superalliage à base de nickel ou en un superalliage de cobalt servant de matériau (2) de base, sur lequel il est déposé du gallium, qui forme un revêtement (4) de protection vis à vis de l'oxydation à base de gallium.

2. Elément (1) résistant aux hautes températures suivant la revendication 1 en un superalliage à base de nickel ou en cobalt servant de matériau (2) de base, ayant un alliage (3) de protection choisi dans la classe des alliages MCrAlY, sur lesquels (3) il est déposé un revêtement (4) de protection vis à vis de l'oxydation à base de gallium,
dans lequel
a) M est au moins un métal choisi dans le groupe (nickel, cobalt, fer),
b) Cr est le chrome,
c) Al est l'aluminium et
(d) Y est l'yttrium et/ou un métal choisi dans le groupe (scandium, lanthane, cérium),
alliage (3) de protection sur lequel est déposé le revêtement (4) de protection vis à vis de l'oxydation.

3. Elément (1) suivant la revendication 2,
dans lequel il est présent, entre le revêtement (4) de protection vis à vis de l'oxydation et l'alliage (3) de protection, une zone (8) d'une phase intermétallique comprenant du gallium, du nickel et/ou du cobalt.

4. Elément (1) suivant l'une des revendications précédentes, qui est un élément (1) d'une installation de turbine à gaz, notamment une aube (1) de turbine à gaz ou un élément (14) pour un revêtement de chambre de combustion.

5. Elément (1) suivant la revendication 4,
qui est une aube (1) de turbine à gaz d'une turbine à gaz à poste fixe.

6. Elément (1) suivant la revendication 4,
qui est une aube (1) de turbine à gaz d'un groupe motopropulseur.

7. Elément (1) suivant la revendication 5 ou 6,
qui a un canal (6) de refroidissement ayant une paroi (7) de canal de refroidissement, sur laquelle est déposé au moins en partie le revêtement (4) vis à vis de l'oxydation.

8. Procédé de production d'une protection vis à vis de l'oxydation pour un élément (1) résistant aux hautes températures, notamment une aube (1) de turbine à gaz, cet élément étant fabriqué en un superalliage à base de nickel ou en un superalliage à base de cobalt servant de matériau (2) de base, du gallium étant, pour la formation d'un revêtement (4) de protection vis à vis de l'oxydation, déposé sur l'élément (1).

9. Procédé suivant la revendication 8,
dans lequel on dépose sur le matériau (2) de base un alliage (3) de protection choisi dans la classe des alliages de MCrAIY, dans lesquels :
a) M est au moins un métal choisi dans le groupe (nickel, cobalt, fer),
b) Cr est le chrome,
c) Al est l'aluminium et
(d) Y est l'yttrium et/ou un métal choisi dans le groupe (scandium, lanthane, cérium),
alliage (3) de protection sur lequel est déposé le gallium.

10. Procédé suivant la revendication 8 ou 9,
dans lequel on soumet l'élément (1) à haute température à un halogénure de gallium (10) gazeux et on dépose ainsi du gallium sur l'élément (1).

11. Procédé suivant l'une des revendications 8 à 10,
dans lequel l'élément (1) est une aube (1) de turbine à gaz ayant un canal (6) de refroidissement, dans lequel un halogénure de gallium (10) gazeux passe à haute température, halogénure de gallium gazeux à partir duquel du gallium se dépose sur la paroi (7) du canal (6) de refroidissement.
